**Europäisches Patentamt**

**European Patent Office**

**Office européen des brevets**

(19)

(11) **EP 1 497 910 B1**

(12) **EUROPÄISCHE PATENTSCHRIFT**

(45) Veröffentlichungstag und Bekanntmachung des Hinweises auf die Patenterteilung:
**05.10.2005 Patentblatt 2005/40**

(21) Anmeldenummer: 03718756.4

(22) Anmeldetag: **15.04.2003**

(51) Int Cl.$^7$: **H02M 3/335**

(86) Internationale Anmeldenummer:
**PCT/EP2003/003888**

(87) Internationale Veröffentlichungsnummer:
**WO 2003/092148 (06.11.2003 Gazette 2003/45)**

(54) **SCHALTNETZTEILANORDNUNG**

SWITCHED-MODE POWER SUPPLY ARRANGEMENT

ENSEMBLE ALIMENTATION A DECOUPAGE

(84) Benannte Vertragsstaaten:
**CH DE FR GB IT LI**

(30) Priorität: **25.04.2002 DE 10218456**

(43) Veröffentlichungstag der Anmeldung:
**19.01.2005 Patentblatt 2005/03**

(73) Patentinhaber: **ABB PATENT GmbH**
**68526 Ladenburg (DE)**

(72) Erfinder:
- **NAGEL, Andreas**
 **58553 Halver (DE)**
- **MAST, Jochen**
 **69221 Heidelberg (DE)**

(74) Vertreter: **Miller, Toivo**
**ABB Patent GmbH,**
**Wallstadter Strasse 59**
**68526 Ladenburg (DE)**

(56) Entgegenhaltungen:

| | |
|---|---|
| EP-A- 0 740 388 | EP-A- 1 020 973 |
| WO-A-01/52415 | WO-A-01/79019 |
| WO-A-02/059628 | FR-A- 2 808 629 |
| GB-A- 2 045 012 | SU-A- 266 037 |
| US-A- 3 568 035 | US-A- 3 654 542 |
| US-A- 4 370 607 | US-A- 5 023 768 |
| US-A- 5 210 780 | US-A- 5 835 367 |

- **PATENT ABSTRACTS OF JAPAN vol. 1997, no. 03, 31. März 1997 (1997-03-31) & JP 08 316809 A (IWAI HIROSHI), 29. November 1996 (1996-11-29)**
- **PATENT ABSTRACTS OF JAPAN vol. 1999, no. 05, 31. Mai 1999 (1999-05-31) & JP 11 055097 A (IWAI HIROSHI), 26. Februar 1999 (1999-02-26)**

EP 1 497 910 B1

**Beschreibung**

Die Erfindung betrifft eine potentialgetrennte Stromversorgung von Gate-Units gemäß dem Oberbegriff des Patentanspruchs 1, also eine Stromversorgung von Ansteuereinheiten zur Steuerung von Leistungs-Halbteiterschaltern in Hochspannungs-Schaltern oder Konvertern, in denen mehrere Halbleiterschalter in Reihe geschaltet sind. Dabei sind in solchen Hochspannungsanordnungen IGCTs, GTOs, Thyristoren, MOSFETs und IGBTs die typischen verwendeten, elektrisch in Reihe geschalteten Halbleiterschalter, wobei für die Stromversorgung der Ansteuereinheiten eine Potentialtrennung bei großen Spannungsunterschieden benötigt wird.

Eine derartige potentialgetrennte Stromversorgung von Gate-Units wird in der WO 02 059628 A vorgeschlagen.

Stand der Technik ist die Versorgung der Ansteuereinheiten durch jeweils einzelne Stromversorgungseinrichtungen mit hoher Potentialtrennung, entweder

   a) mittels an einen Niederspannungs-AC-Bus parallel angeschlossenen hochisolierenden Transformatoren, meistens in 50 Hz-Technik, oder
   b) mittels an eine Gleichspannungsversorgung angeschlossenen, eingangsspannungsseitig parallelgeschalteten separaten hochisolierenden DC/DC-Wandlern.

Nachteile der bekannten Anordnungen sind im Fall der Variante a), daß Transformatoren in der typischen 50 Hz-Technik voluminös, schwer und teuer sind, und der Montageaufwand erheblich ist.

Bei den Varianten a) und b) ergeben sich Probleme mit Isolation/Kriechstrecken, da der Versorgungs-AC- respektive DC-Bus bis zu jeder Schalterstufe geführt und dort angezapft werden muß.

In der Hochleistungs-Stromrichtertechnik, insbesondere wenn eine Reihenschaltung von Leitungsschaltelementen zum Einsatz kommt, bestehen erhöhte Anforderungen an die Isolation verwendeter Transformatoren in den jeweiligen Ansteuerungen und insbesondere auch an deren parasitäre kapazitive Kopplung zwischen Primär- und Sekundärkreis. Diese Kopplung muß unbedingt sehr niedrig sein, um Beeinflussungen der Elektronik auf den Gate-Units durch Lade- / Entladeströme der parasitären Koppelkapazitäten zu vermeiden. Nach dem Stand der Technik werden deshalb vergossene Übertrager eingesetzt, um den Isolationsanforderungen gerecht zu werden. Diese besitzen in der Regel aber eine unerwünscht hohe parasitäre Koppelkapazität, insbesondere wenn es sich um Transformatoren in 50 Hz-Technik handelt.

Der Erfindung liegt daher die Aufgabe zugrunde, eine potentialgetrennte Stromversorgung von Gate-Units, d. h. eine zur Stromversorgung von auf unterschiedlichem Hochspannungspotential befindlichen Verbrauchern geeignete Anordnung anzugeben, mit der sowohl hohen Anforderungen an die Potentialtrennung, als auch an eine kleine Koppelkapazität entsprochen werden kann.

Diese Aufgabe wird durch eine Anordnung gelöst, die die im Anspruch 1 angegebenen Merkmale aufweist. Vorteilhafte Ausgestaltungen sind in weiteren Ansprüchen angegeben.

Mit der Erfindung wird demnach eine Anordnung vorgeschlagen, die mehrere Schaltnetzteilübertrager enthält, wobei die Primärwicklungen der Schaltnetzteilübertrager elektrisch in Reihe geschaltet sind. An die Sekundärwicklungen der Schaltnetzteilübertrager sind jeweils Ausgangsspannungsregler angeschlossen. Die Reihenschaltung der Primärwicklungen ist mit dem Ausgang einer Wechselstromquelle verbunden.

Die Schaltnetzteilübertrager enthalten jeweils einen Ferrit-Ringkern, der die jeweilige Sekundärwicklung trägt, wobei die Reihenschaltung der Primärwicklungen als eine durch alle Ferrit-Ringkerne geführte hochspannungsisolierte Leiterschleife ausgeführt ist.

Vorteilhaft ist der zur Realisierung der Schaltnetzteilanordnung erforderliche geringe Aufwand. Die Schaltnetzteilanordnung ist dadurch insbesondere für Hochspannungs-Stromrichter mit einer großen Anzahl in Reihe geschalteter Einzelelemente geeignet, da die Anzahl der den einzelnen Gate-Units zugeordneten Bauelemente der Schaltnetzteilanordnung minimal ist. Die Übertrager sind kleinvolumig und können direkt auf die übliche Leiterplatte der Gate-Units montiert werden.

Einer der Vorteile besteht weiterhin darin, daß Probleme mit Kriechstrecken nicht auftreten, da der Primärkreis nicht aufgetrennt und angezapft werden muß. Durch eine besonders günstige Ausführung des Primärkreises und der Übertrager wird auch eine sehr geringe parasitäre Koppelkapazität erzielt.

Zur Versorgung von Ansteuerschaltungen werden in der Regel stabilisierte positive und negative Spannungen benötigt. Mit der vorgeschlagenen Anordnung ist die Erzeugung solcher Versorgungsspannungen auf besonders einfache Weise möglich. Durch die gegebene prinzipiell verlustlose Regelung ist auch die Übertragung relativ hoher Leistungen von einigen 100 W pro Übertrager problemlos möglich. Durch sekundärseitig unterschiedliche Windungszahlen oder Zusatzwicklungen können auch unterschiedlich hohe Ausgangsspannungen erzeugt werden.

Eine weitere Erläuterung der Erfindung erfolgt nachstehend anhand eines Ausführungsbeispiels, das in Zeichnungsfiguren dargestellt ist.

Es zeigt:

Fig. 1    eine Prinzipschaltung der Schaltnetzteilanordnung,

Fig. 2    eine bevorzugte Anordnung der Schaltnetzteilübertrager mit Ringkemen und einer primärseitigen Leiterschleife, und

Fig. 3 Schaltungsdetails der Schaltnetzteilanordnung.

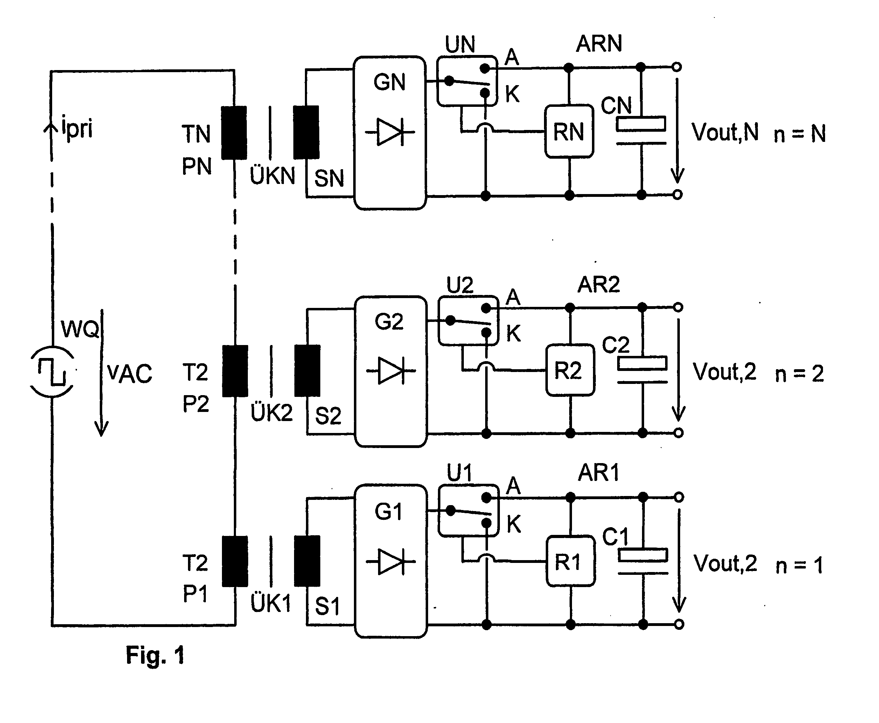

Fig. 1 zeigt eine Prinzipschaltung der vorgeschlagenen Schaltnetzteilanordnung. Die Anordnung enthält mehrere Schaltnetzteilübertrager T1, T2 bis TN, mit jeweiligen Primärwicklungen P1, P2 bis PN, Sekundärwicklungen S1, S2 bis SN und Übertragerkernen ÜK1, ÜK2 bis ÜKN. Eine Reihenschaltung der Primärwicklungen P1, P2 bis PN bildet einen Primärkreis, in dem ein Primärstrom $i_{pri}$ fließt, den eine Wechselstromquelle WQ mit der Wechselspannung $V_{AC}$ liefert. Der gelieferte Strom kann beispielsweise rechteckförmig sein, kann aber auch eine andere vorteilhafte Stromkurvenform haben, insbesondere eine sinusförmige.

An die Sekundärwicklungen S1, S2 bis SN ist jeweils ein Gleichrichter G1, G2 bis GN angeschlossen, auf den jeweils ein einpoliger elektronischer Umschalter U1, U2 bis UN folgt. Mittels des Umschalter U1, U2 bis UN wird jeweils der Gleichrichterausgang gesteuert durch einen jeweiligen Regler R1, R2 bis RN entweder - in einer Schalterstellung A - mit einem jeweiligen Ausgangskondensator C1, C2 bis CN verbunden, oder aber - in einer Schalterstellung K - kurzgeschlossen. Die sekundärseitigen Anordnungen bilden jeweils Ausgangsspannungsregler AR1, AR2 bis ARN.

Mit der dargestellten Einrichtung kann auf jeder der Stufen 1 bis N, also mittels der Ausgangsspannungsregler AR1, AR2 bis ARN, die jeweils benötigte Leistung ausgekoppelt werden. Beispielhaft sei dazu ein Extremfall unterschiedlicher Ausgangsleistungen beschrieben: Dabei wird angenommen, daß nur auf einer einzigen Stufe, z.B. Stufe 1 die volle Leistung benötigt wird, und alle anderen Stufen sich im Leerlauf befinden. Dann werden die Umschalter U2 bis UN in den Stufen 2 bis N für den größten Teil der Zeit in Stellung "K", derjenige auf der Stufe 1 mit hohem Leistungsbedarf aber auf "A" stehen. Die Amplitude der Spannung über der Wechselstromquelle WQ stellt sich dabei auf

$$V_{AC} = \frac{1}{\ddot{u}}Vout,1$$

ein. Das bedeutet, daß die von der Quelle WQ gelieferte Leistung exakt so groß wie die am Ausgang der Stufe 1 abgegebene Leistung ist, wenn die Bauelemente als verlustlos angesehen werden. Mit ü ist das Übertrager-Windungszahlverhältnis bezeichnet; Vout,1 ist die Ausgangsspannung des Ausgangsspannungsreglers AR 1.

Neben den oben bereits genannten Vorteilen zeichnet sich die vorgeschlagene Anordnung durch eine sehr hohe inhärente Robustheit aus:

- Die eventuelle magnetische Sättigung der Übertragerkerne ÜK1, ÜK2 bis ÜKN hat keinen Einfluß auf die Funktion oder die Betriebssicherheit der Anordnung. Sättigung kann auftreten, wenn die Wechselstromquelle WQ oder die Gleichrichter G1, G2 bis GN und die Umschalter U1, U2 bis UN ein nichtideales Verhalten aufweisen, was in der Praxis regelmäßig der Fall sein wird. Sollten also ein oder mehrere der Übertrager T1, T2 bis TN während der positiven Halbwelle des Primärstromes $i_{pri}$ sättigen, bricht die Spannung über diesen Übertragern zusammen. Die Auswirkung ist also die selbe, wie wenn sich die Schalter S1 bis SN in Stellung "K" befinden, was einem normalen Betriebsfall entspricht.

- Sollte auf einer oder mehrerer der Sekundärseiten ein Fehler auftreten, werden die übrigen Stufen weiterhin problemlos versorgt und bleiben voll funktionsfähig. Dabei ist es unerheblich, ob der Fehler zu einem Kurzschluß, einem Leerlauf oder einem beliebigen Belastungszustand führt:

  a) Der mögliche Extremfall "Kurzschluß" entspricht dem normalen Betriebszustand, wenn sich der Umschalter Sx in Stellung "K" befindet. b) Der andere mögliche Extremfall entsteht, wenn der Fehler zu einem Leerlauf am Übertragerausgang führt. Auch das ist kein Problem; denn der Übertragerkern der betroffenen Stufe sättigt lediglich bei jeder Halbwelle von $i_{pri}$. Die Versorgung der anderen Stufen bleibt unbeeinträchtigt. Das funktioniert deshalb, weil der unbelastete Übertrager primärseitig eine hohe Impedanz darstellt. Die Spannung über der Quelle WQ wird dadurch kurzzeitig sehr hoch, so daß der betroffene Kern nach sehr kurzer Zeit sättigt. Für den überwiegenden Teil der Schaltperiode ist damit Normalbetrieb für die verbleibenden intakten Stufen gesichert.

Die Erzeugung mehrerer positiver oder negativer Ausgangsspannungen ist besonders einfach möglich durch Aufbringen zusätzlicher Wicklungen auf die einzelnen Übertrager. Dadurch, daß die Ausgangskondensatoren Cx in der Stellung "A" der Umschalter Sx direkt mit dem Übertrager Tx verbunden sind, werden sie effektiv parallelgeschaltet. Dabei sind pro Übertrager Tx nur an einer einzigen Wicklung ein Spannungsregler Rx und ein Umschalter Ux notwendig.

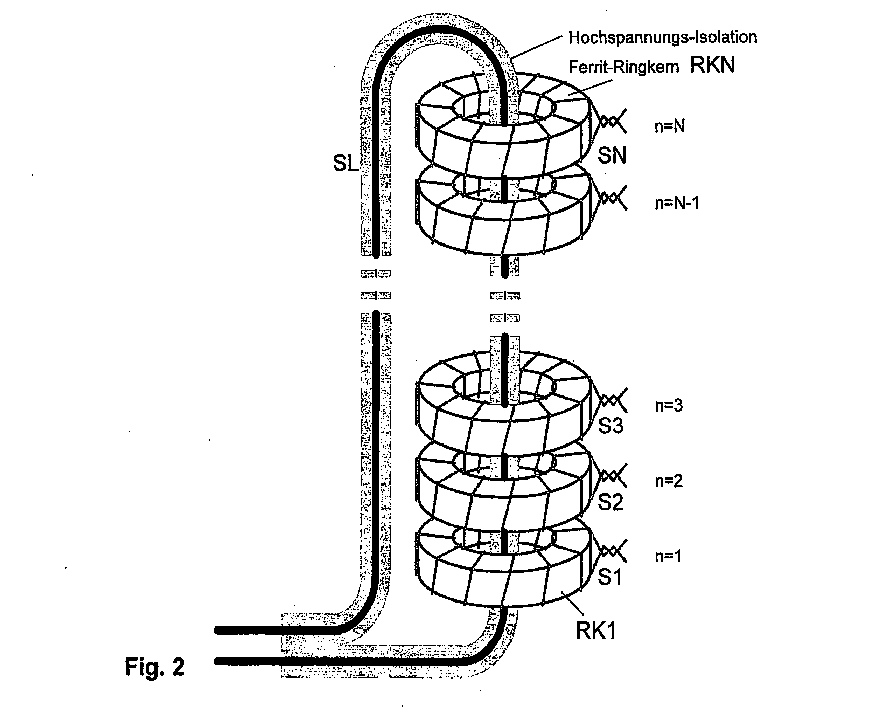

Die Übertrager Tx können besonders vorteilhaft als Stapel ausgeführt werden, wie in Fig. 2 schematisiert dargestellt ist. Dabei sind die Übertragerkeme ÜK1, ÜK2 bis ÜKN als Ferrit-Ringkerne RK1 bis RKN ausgeführt, die jeweils eine Sekundärwicklung S1 bis SN tragen. Die erforderliche Reihenschaltung von Primärwicklungen ist als Leiterschleife SL ausgeführt, die durch alle Kernöffnungen geführt und über eine - in Fig. 2 nicht dargestellte - Wechselstromquelle angeschlossen ist. Die nötige Potentialtrennung kann durch den Ringkeminnendurchmesser, die Isolationsbeschaffenheit, z. B. durch Wahl von Material, Dicke, und halbleitende Beschichtung des für die Bildung der Primärwicklung als Leiterschleife SL verwendeten Kabels eingestellt werden.

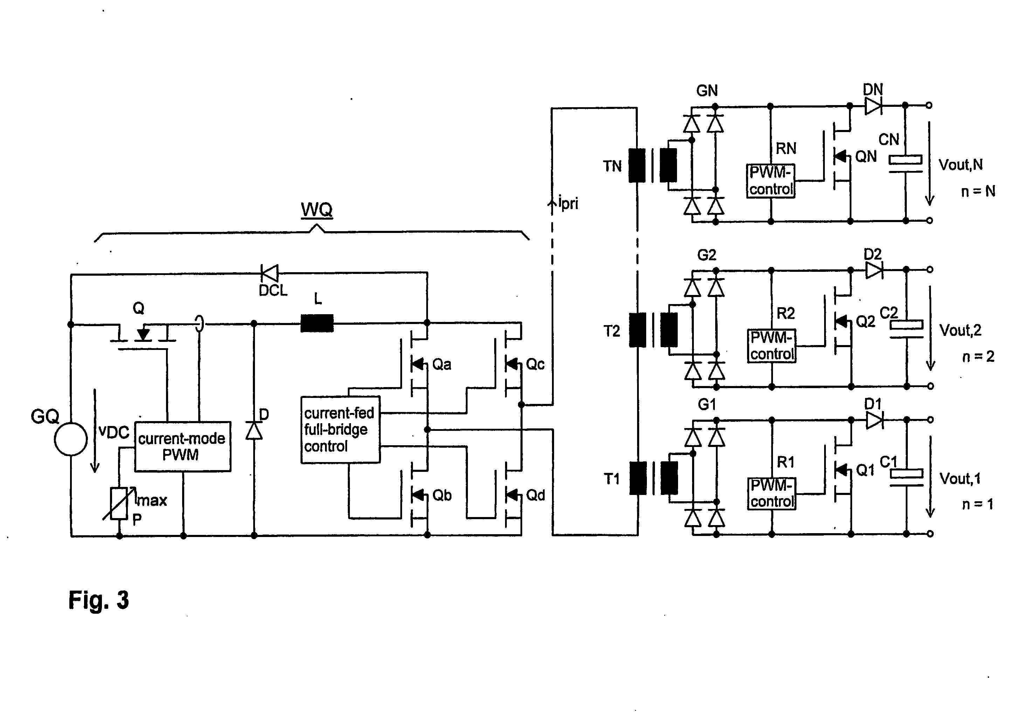

Eine mögliche vorteilhafte Ausführung der Schaltnetzteilanordnung ist in Fig. 3 beispielhaft dargestellt. Die Wechselstromquelle WQ ist dabei als stromgeregelter Tiefsetzsteller ausgeführt. Möglich wäre beispielsweise auch eine Ausführung als Resonanz-Schaltnetzteil. Die dargestellte Wechselstromquelle WQ wird aus einer Gleichstromquelle GQ - mit einer Gleichspannung $V_{DC}$ - gespeist. Die Wechselstromquelle WQ enthält einen elektronischen Schalter Q, der hier beispielhaft als MOSFET ausgeführt ist, wie auch alle anderen Schalter der Anordnung. Weitere Elemente des Tiefsetzstellers sind eine Diode D, eine Drosselspule L und eine PWM-Regelung zur pulsweitenmodulierten Ansteuerung des Schalters Q, mit Stromsollwertvorgabe, hier beispielhaft mittels eines Potentiometers P. Damit wird zunächst aus der Eingangsgleichspannung ein Gleichstrom mit geringem Wechselanteil erzeugt. Eine nachgeschaltete H-Brücke mit Schaltern Qa...Qd erzeugt aus diesem Gleichstrom den zur Speisung des Primärkreises nötigen Wechselstrom $i_{pri}$. Die H-Brücke wird so gesteuert, daß immer ein Strompfad für den durch die Drosselspule L fließenden Strom gegeben ist, also eine sogenannte "überlappende Steuerung" erreicht wird.

Der in Fig. 1 dargestellte jeweilige sekundärseitige einpolige Umschalter U1 bis UN ist in der Anordnung gemäß Fig. 3 als Halbleiterschalter Q1 bis QN, beispielsweise als MOSFET, in Verbindung mit einer Diode D1 bis DN realisiert. Der jeweilige Gleichrichter G1 bis GN ist als Brückenschaltung ausgeführt; je nach Anforderungen kann auch eine Mittelpunktschaltung eingesetzt werden. Die sekundärseitigen Spannungsregler R1 bis RN steuern die Schalter Q1 bis QN mittels Pulsweitenmodulation PWM an; zum Beispiel kann diese PWM mittels Zweipunktregler (Hystereseregler) erreicht werden.

## Patentansprüche

**1.** Potentialgetrennte Stromversorgung von Gate-Units eines Hochspannungs-Stromrichters oder Hochspannungs-Schalters mit einer großen Anzahl in Reihe geschalteter Leistungs-Halbleiterschalter,

- wobei zur Stromversorgung jeder Gate-Unit ein Schaltnetzteilübertrager (T1 bis TN) vorgesehen ist, welcher eine Primärwicklung (P1 bis PN) und eine Sekundärwicklung (S1 bis SN) aufweist,
- wobei jeder Schaltnetzteilübertrager (T1 bis TN) einen Ferrit-Ringkern (RK1 bis RKN) aufweist, der die jeweilige Sekundärwicklung (S1 bis SN) trägt,
- wobei eine mit dem Ausgang einer Wechselstromquelle (WQ) verbundene Reihenschaltung der Primärwicklungen (P1 bis PN) in Form einer durch alle Ferrit-Ringkerne (RK1 bis RKN) geführten, hochspannungsisolierten Leiterschleife (SL) vorgesehen ist,

   **dadurch gekennzeichnet, dass** an jede Sekundärwicklung (S1 bis SN) ein Ausgangsspannungsregler (AR1 bis ARN) angeschlossen ist, welcher aufweist:

   a) einen an die Sekundärwicklung (S1 bis SN) angeschlossenen Gleichrichter (G1 bis GN),
   b) einen auf den Gleichrichter (G1 bis GN) folgenden, einpoligen, mittels eines Spannungsreglers (R1 bis RN) gesteuerten, elektronischen Umschalter (U1 bis UN), welcher den Gleichrichterausgang entweder mit einem jeweiligen Ausgangskondensator (C1 bis CN) verbindet oder kurzschließt.

**2.** Stromversorgung nach Anspruch 1, **dadurch gekennzeichnet, dass** wenigstens einer der Ferrit-Ringkerne (RK1 bis RKN) wenigstens eine Zusatzwicklung trägt.

**3.** Stromversorgung nach Anspruch 1, **dadurch gekennzeichnet, dass** die Wechselstromquelle (WQ) einen Tiefsetzsteller enthält.

## Claims

**1.** DC-isolated power supply for gate units of a high-voltage converter or high-voltage switch having a large number of series-connected power semiconductor switches,

- with a switched-mode power supply transformer (T1 to TN) being provided for supplying power to each gate unit and having a primary winding (P1 to PN) and a secondary winding (S1 to SN),
- with each switched-mode power supply transformer (T1 to TN) having a ferrite toroidal core (RK1 to RKN) to which the respective secondary winding (S1 to SN) is fitted,
- with a series circuit, which is connected to the output of an AC power source (WQ), of the primary windings (P1 to PN) being provided in the form of a high-voltage-insulated conductor loop (SL) which is passed through all the ferrite toroidal cores (RK1 to RKN),

   **characterized in that** each secondary winding (S1 to SN) is connected to an output voltage regulator (AR1 to ARN) which has:

   a) a rectifier (G1 to GN) which is connected to the secondary winding (S1 to SN),
b) a single-pole electronic changeover switch (U1 to UN) which follows the rectifier (G1 to GN), is controlled by means of a voltage regulator (R1 to RN) and either connects the rectifier output to a respective output capacitor (C1 to CN) or short-circuits it.

2. Power supply according to Claim 1, **characterized in that** at least one of the ferrite toroidal cores (RK1 to RKN) is fitted with at least one additional winding.

3. Power supply according to Claim 1, **characterized in that** the AC power source (WQ) contains a step-down controller.

## Revendications

1. Alimentation à découpage des portes d'un redresseur à haute tension ou d'un commutateur à haute tension comportant un grand nombre de commutateurs semi-conducteurs de puissance connectés en série,

dans laquelle il est prévu pour l'alimentation de chaque porte un transformateur (T1 à TN), qui comporte un enroulement primaire (P1 à PN) et un enroulement secondaire (S1 à SN),

dans laquelle chaque transformateur (T1 à TN) comprend un noyau annulaire (RK1 à RKN) en ferrite qui porte l'enroulement secondaire (S1 à SN) concerné,

dans laquelle il est prévu un branchement série des enroulements primaires (P1 à PN) connecté à la sortie d'une source de courant alternatif (WQ) sous la forme d'une boucle de conducteur (SL) à isolation à haute tension passant dans tous les noyaux annulaires (RK1 à RKN) en ferrite,

**caractérisée par le fait qu'**à chaque enroulement secondaire (S1 à SN) est relié un régulateur de tension de sortie (AR1 à ARN) qui présente:

a) un redresseur (G1 à GN) connecté à l'enroulement secondaire (S1 à SN),
b) un commutateur électronique (U1 à UN) unipolaire, commandé par un régulateur de tension (R1 à RN), placé derrière le redresseur (G1 à GN), qui soit connecte la sortie de redresseur à un condensateur de sortie (C1 à CN) correspondant, soit la met en court-circuit.

2. Alimentation selon la revendication 1, **caractérisée par le fait qu'**au moins un des noyaux annulaires (RK1 à RKN) en ferrite porte au moins un enroulement supplémentaire.

3. Alimentation selon la revendication 1, **caractérisée par le fait que** la source de courant alternatif (WQ) contient un abaisseur de tension.

**Fig. 1**

EP 1 497 910 B1

Hochspannungs-Isolation

Ferrit-Ringkern  RKN

n=N

SN

n=N-1

SL

n=3

S3

n=2

S2

n=1

S1

RK1

**Fig. 2**

EP 1 497 910 B1

**Fig. 3**